# EUROPEAN PATENT APPLICATION

(11) **EP 3 124 568 A1**
(43) Date of publication of application: **01.02.2017**
(21) Application number: 15770081.6
(22) Date of filing: 23.03.2015
(51) Int. Cl.: C09K 3/10, B32B 27/30, B32B 27/40, H01L 31/048, H01L 51/50, H05B 33/04

(54) **SEALING SHEET, AND SEALING STRUCTURE AND DEVICE**

(30) Priority: 27.03.2014 JP 2014065926
(71) Applicant: LINTEC Corporation, Tokyo 173-0001 (JP)
(72) Inventor: KAWADA, Satoshi, Tokyo 173-0001 (JP); MATSUSHIMA, Masaru, Tokyo 173-0001 (JP)
(74) Representative: Gille Hrabal
(86) International application number: PCT/JP2015/058793
(87) International publication number: WO 2015/146935

(57) **Abstract**

A sealing sheet having a resin layer comprising a resin part (A) formed by a resin composition containing one or more resins selected from the group consisting of an acrylic-based resin and a urethane-based resin, and a resin part (B) having a water vapor transmission rate measured in conformity with JIS K 7129 of 15 g/m²/day or less, in which the resin part (A) and the resin part (B) are present on at least one surface of the resin layer. The sealing sheet excels in a suppressing effect on moisture intrusion of the sealing sheet itself, and, when manufacturing a sealing structure, excels in an effect to prevent moisture intrusion into the sealing structure from between a substrate (adherend) and the sealing sheet.

## Description

### Technical Field

The present invention relates to a sealing sheet, a sealing structure obtained by sealing with the sealing sheet, and a device having the sealing sheet.

### Background Art

An organic EL element is very weak in moisture, and degradation proceeds only by absorption of moisture in the atmosphere. A method for completely blocking moisture that intrudes from the atmosphere has been studied for preventing the foregoing degradation of the organic EL element due to the moisture absorption. For example, a method for sealing an organic EL element for completely blocking moisture, and a method for trapping intruding moisture using a calcium oxide desiccant sheet have been known.

As the method for sealing an organic EL element, for example, a method for sealing an organic EL element by an adherent sealing composition film containing an isobutylene resin has been known (for example, refer to PTL 1).

### Citation List

### Patent Literature

PTL 1: Japanese Translation of PCT International Application Publication No. JP-T-2009-524705

### Summary of Invention

### Technical Problem

However, according to the study of the present inventors, in an organic device manufactured using the above-described adherent sealing composition film, it was found that moisture intrusion into a sealing structure from a bonding surface between the adherent sealing composition film and a substrate (adherend) causes generation of dark spots and that a problem of insufficient durability under heating and humidifying occurs.

The present invention has been made in view of the above-described circumstances, and an object of the present invention is to provide a sealing sheet which excels in a suppressing effect on moisture intrusion of the sealing sheet itself, and, when manufacturing a sealing structure, excels in an effect to prevent moisture intrusion into the sealing structure from a bonding surface between a substrate (adherend) and the sealing sheet, and a sealing structure obtained by sealing with the sealing sheet, which excels in durability under heating and humidifying.

### Solution to Problem

The present inventors found that the above-described problems can be solved by a sealing sheet having a resin layer in which a resin part (A) which excels in interface adherence with a substrate (adherend) and a resin part (B) which has a low water vapor transmission rate and excels in a suppressing effect on moisture intrusion are present on one surface thereof to complete the present invention.

More specifically, the present invention provides the following [1] to [17].
[1] A sealing sheet having a resin layer comprising a resin part (A) formed by a resin composition containing one or more resins selected from the group consisting of an acrylic-based resin and a urethane-based resin, and a resin part (B) having a water vapor transmission rate measured in conformity with JIS K 7129 of 15 g/m²/day or less, wherein the resin part (A) and the resin part (B) are present on at least one surface of the resin layer.
[2] The sealing sheet according to the above-described [1], wherein, on the at least one surface of the resin layer, the resin part (A) or the resin part (B) forms a closed region, and the other resin part is present in the closed region.
[3] The sealing sheet according to the above-described [1] or [2], wherein, on the at least one surface of the resin layer, a ratio of a total surface area of the resin part (A) to a total surface area of the resin part (B) [(A) area/(B) area] is 10/90 to 90/10.
[4] The sealing sheet according to any one of the above-described [1] to [3], wherein the resin layer is provided on a support.
[5] The sealing sheet according to the above-described [4], wherein only the resin part (B) is present on a surface of the resin layer on the side of the support and the resin part (A) and the resin part (B) are present on the other surface of the resin layer.
[6] The sealing sheet according to the above-described [4] or [5], wherein the support is a gas barrier film.
[7] The sealing sheet according to any one of the above-described [1] to [6], wherein a resin composition forming the resin part (B) contains one or more resins selected from the group consisting of a butyl rubber, a polyisobutylene-based resin, a styrene-based copolymer, a polyisoprene-based resin, a polybutadiene-based resin, and a polybutene-based resin.
[8] The sealing sheet according to the above-described [7], wherein the resin composition forming the resin part (B) contains a polyisobutylene-based resin having a mass-average molecular weight of 270,000 to 600,000 (b-1) and a polyisobutylene-based resin having a mass-average molecular weight of 50,000 to 250,000 (b-2).
[9] The sealing sheet according to the above-described [7], wherein the resin composition forming the resin part (B) contains a polyisobutylene-based resin having a mass-average molecular weight of 20,000 or more (b-3), and one or more styrene-based copolymers selected from the group consisting of a styrene-butadiene-styrene triblock copolymer (SBS), a styrene-(ethylene-co-butylene)-styrene triblock copolymer (SEBS), a styrene-isobutylene diblock copolymer (SIB), and a styrene-isobutylene-styrene triblock copolymer (SIBS), (b-4).
[10] The sealing sheet according to the above-described [9], wherein a softening point of the styrene-based copolymer (b-4) is 80 to 200°C.
[11] The sealing sheet according to any one of the above-described [1] to [10], wherein the resin composition forming the resin part (B) further contains a tackifier having a softening point of 135°C or less.
[12] The sealing sheet according to any one of the above-described [1] to [11], which is used for sealing an organic EL element.
[13] A sealing structure obtained by sealing an object to be sealed, which is provided on a substrate (adherend), with the sealing sheet according to any one of the above-described [1] to [12].
[14] The sealing structure according to the above-described [13], wherein the object to be sealed is positioned in a region closed by the resin part (B) on a surface of the sealing sheet.
[15] The sealing structure according to the above-described [13] or [14], wherein the object to be sealed is an organic EL element, an organic EL display element, a liquid crystal display element, or a solar cell element.
[16] The sealing structure according to any one of the above-described [13] to [15], wherein the substrate (adherend) is a glass plate or a gas barrier film.
[17] A light-emitting device, a display device, or a solar cell having the sealing sheet according to any one of the above-described [1] to [12] or the sealing structure according to any one of the above-described [13] to [16].

### Advantageous Effects of Invention

A sealing sheet of the present invention excels in a suppressing effect on moisture intrusion of the sealing sheet itself, and, when manufacturing a sealing structure, excels in an effect to prevent moisture intrusion into the sealing structure from between a substrate (adherend) and the sealing sheet. Furthermore, a sealing structure obtained by sealing with the sealing sheet excels in durability under heating and humidifying.

### Brief Description of Drawings

[Fig. 1] Fig. 1 shows plan views each schematically illustrating one example of a resin layer of a sealing sheet according to an embodiment of the present invention.
[Fig. 2] Fig. 2 shows cross-sectional views each schematically illustrating one example of a sealing sheet according to the embodiment of the present invention.
[Fig. 3] Fig. 3 is a diagram schematically illustrating one example of a sealing structure according to the embodiment of the present invention.
[Fig. 4] Fig. 4 is a diagram schematically illustrating another example of a sealing structure according to the embodiment of the present invention.

### Description of Embodiments

### [Sealing sheet]

A sealing sheet of the present invention is has a configuration in which the sealing sheet has a resin layer comprising a resin part (A) formed by a resin composition containing one or more resins selected from the group consisting of an acrylic-based resin and a urethane-based resin, and a resin part (B) having a water vapor transmission rate measured in conformity with JIS K 7129 of 15 g/m²/day or less, the resin part (A) and the resin part (B) being present on at least one surface of the resin layer.

When the sealing sheet of the present invention having such a configuration is used, moisture that can intrude from between the sealing sheet and the substrate (adherend) can be effectively suppressed by the resin part (A) having good interface adherence with a substrate (adherend), in addition to a suppressing effect on moisture intrusion of the entire sealing sheet by the resin part (B) having a low water vapor transmission rate, and thus durability of a sealing structure and a device having the sealing sheet under heating and humidifying can be improved.

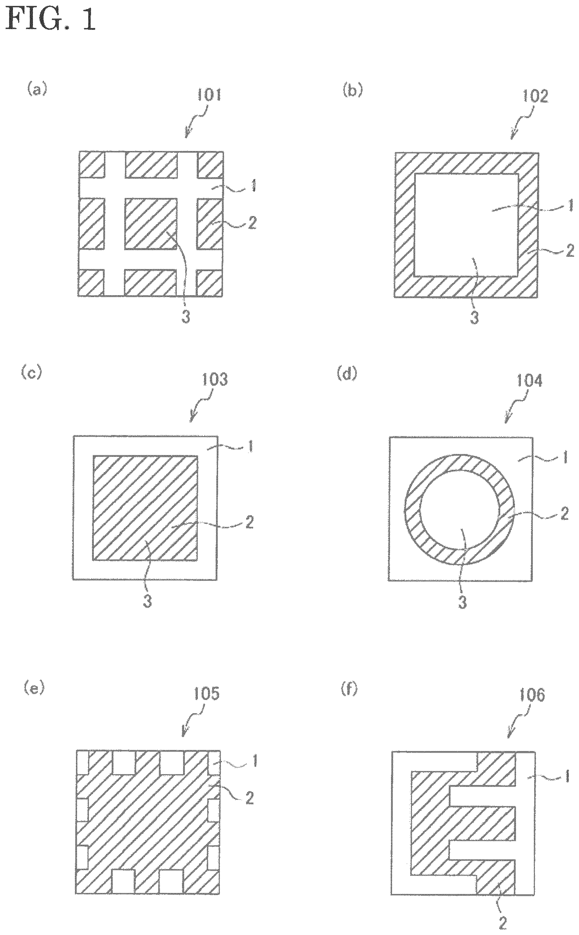

Examples of the resin layer of the sealing sheet according to an embodiment of the present invention will be described with reference to Figs. 1(a) to (f), but the sealing sheet of the present invention is not limited to the following examples as long as the effects of the present invention are exhibited.

At least one surface of the resin layer has, for example, shapes illustrated in Figs. 1(a) to (f).

As illustrated in Figs. 1(a) to (f), a resin part (A) 1 and a resin part (B) 2 are present on at least one surface of the resin layer of the sealing sheet.

In the configuration illustrated in Fig. 1(a), on a surface 101 of the resin layer of the sealing sheet, the resin part (A) 1 and the resin part (B) 2 are arranged in a lattice pattern, the resin part (A) 1 forms a closed region 3, and the resin part (B) 2 is formed in the closed region 3.

In the configuration illustrated in Fig. 1(b), on a surface 102 of the resin layer of the sealing sheet, the resin part (B) 2 is arranged on an outer edge of the resin part (A) 1, the resin part (B) 2 forms a closed region 3, and the resin part (A) 1 is arranged in the closed region 3.

In the configuration illustrated in Fig. 1(c), on a surface 103 of the resin layer of the sealing sheet, the resin part (A) 1 is arranged on an outer edge of the resin part (B) 2, the resin part (A) 1 forms a closed region 3, and the resin part (B) 2 is arranged in the closed region 3.

In the configuration illustrated in Fig. 1(d), on a surface 104 of the resin layer of the sealing sheet, the resin part (B) 2 is arranged in a circular pattern in the resin part (A) 1, the resin part (B) 2 forms a closed region 3, and the resin part (A) 1 is arranged in the closed region 3.

In the configuration illustrated in Fig. 1(e), on a surface 105 of the resin layer of the sealing sheet, the respective resin parts (A) 1 are intermittently arranged on an outer edge of the sealing sheet so as to secure sufficient interface adherence, and the resin part (B) 2 is arranged on a part other than the respective resin parts (A) 1.

In the configuration illustrated in Fig. 1(f), on a surface 106 of the resin layer of the sealing sheet, at least one side of the respective resin parts (A) 1 is arranged to be in contact with an outer edge of the sealing sheet so as to secure sufficient interface adherence, and the resin part (B) 2 is arranged on a part other than the respective resin parts (A) 1.

It is to be noted that, although the configurations illustrated in Figs. 1(e) and (f) may be used, a configuration in which, on at least one surface of the resin layer, the resin part (A) 1 or the resin part (B) 2 forms the closed region 3 while the other resin part is present in the closed region, as illustrated in Figs. 1(a) to (d), is preferable from the viewpoint of improving the interface adherence between the substrate (adherend) and the sealing sheet to improve the suppressing effect on moisture intrusion of the sealing sheet. In addition, in Fig. 1(a) and Fig. 1(d), a configuration in which the resin part (A) 1 and the resin part (B) 2 are arranged in an opposite manner may be used.

In addition, on at least one surface of the resin layer, the ratio of the total surface area of the resin part (A) 1 to the total surface area of the resin part (B) 2 [(A) area/(B) area] is preferably 10/90 to 90/10. The ratio [(A) area/(B) area] is more preferably 20/80 to 80/20, and further preferably 25/75 to 75/25.

The thickness of the resin layer is arbitrarily selected depending on the intended use and the like, and is preferably 0.5 to 100 µm, more preferably 1 to 60 µm, and further preferably 3 to 40 µm. When the thickness of the resin layer is 0.5 µm or more, good interface adhesive force to the adherend can be obtained. In contrast, when the thickness of the resin layer is 100 µm or less, the sealing sheet can become advantageous in terms of productivity and easy to be handled.

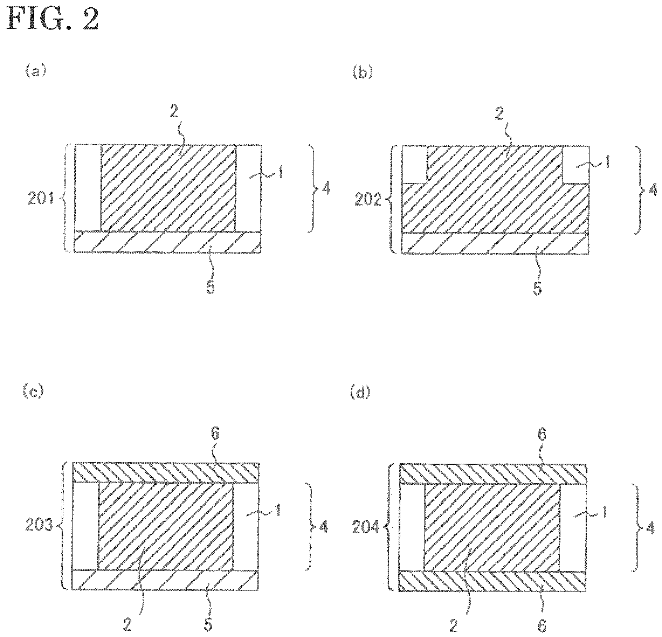

Examples of the configuration of the sealing sheet of the present invention include modes illustrated in cross-sectional views of Figs. 2(a) to (d), but the sealing sheet of the present invention is not limited to these examples as long as the effects of the present invention are exhibited.

Examples of the configuration of the sealing sheet of the present invention include sealing sheets 201 and 202 having a configuration in which a resin layer 4 is provided on a support 5, as illustrated in Figs. 2(a) and (b). In addition, examples thereof include a sealing sheet 203 having a configuration in which a support 5, a resin layer 4, and a release sheet 6 are laminated in this order, as illustrated in Fig. 2(c), and a sealing sheet 204 having a configuration in which a resin layer 4 is sandwiched between two release sheets 6, as illustrated in Fig. 2(d).

In addition, as illustrated in Figs. 2(a) to (c), the resin layer 4 is preferably provided on the support 5. In addition, as illustrated in Fig. 2(b), the resin layer 4 in which only the resin part (B) 2 is present on the surface of the resin layer 4 on the side of the support 5 and the resin part (A) 1 and the resin part (B) 2 are present on the other surface may be used.

The thickness of the sealing sheet of the present invention is arbitrarily adjusted depending on the intended use and the like, and is preferably 0.5 to 1,000 µm, more preferably 1 to 600 µm, further preferably 3 to 400 µm, and still further preferably 5 to 200 µm.

Hereinafter, components contained in the sealing sheet of the present invention will be sequentially described.

### <Resin composition forming resin part (A)>

A resin composition forming the resin part (A) used in the present invention contains one or more selected from the group consisting of an acrylic-based resin and a urethane-based resin.

### (Acrylic-based resin)

Examples of the acrylic-based resin used in the present invention include an acrylic-based resin having a structural unit derived from an alkyl (meth)acrylate, and an acrylic-based resin having a structural unit (p1) derived from an alkyl (meth)acrylate having 4 or more carbon atoms (hereinafter, also referred to as "monomer (p1)") is preferable.

From the viewpoint of improving the interface adhesive force of the sealing sheet, the number of carbon atoms of an alkyl group of the monomer (p1) is preferably 4 to 20, more preferably 4 to 12, and further preferably 4 to 6. In addition, the alkyl group of the monomer (p1) may be straight-chain or branched-chain.

Examples of the monomer (p1) include butyl (meth)acrylates such as n-butyl (meth)acrylate and isobutyl (meth)acrylate, pentyl (meth)acrylate, hexyl (meth)acrylate, 2-ethylhexyl (meth)acrylate, isooctyl (meth)acrylate, lauryl (meth)acrylate, and stearyl (meth)acrylate.

It is to be noted that these monomers (p1) may be used singly or in combination of two or more kinds thereof.

Among them, from the viewpoint of improving the interface adhesive force of the sealing sheet, butyl (meth)acrylates are preferable, and n-butyl (meth)acrylate is more preferable.

From the viewpoint of further improving the interface adhesive force of the sealing sheet, the acrylic-based resin is preferably a resin further having a structural unit (p2) derived from a functional group-containing monomer (p2) (hereinafter, also referred to as "monomer (p2)") together with the structural unit (p1).

It is to be noted that the term "functional group" in "functional group-containing monomer (p2)" here indicates a functional group that can react with a cross-linking agent described below to be the origin of the cross-linkage or a functional group having a cross-linkage facilitation effect.

Examples of the monomer (p2) include hydroxyl group-containing monomers, carboxy group-containing monomers, amino group-containing monomers, and epoxy group-containing monomers. These monomers (p2) may be used singly or in combination of two or more kinds thereof.

Among them, hydroxyl group-containing monomers and carboxy group-containing monomers are preferable.

Examples of the hydroxyl group-containing monomers include hydroxyalkyl (meth)acrylates such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, and 4-hydroxybutyl (meth)acrylate; and unsaturated alcohols such as vinyl alcohol and allyl alcohol.

Examples of the carboxy group-containing monomers include ethylenic unsaturated monocarboxylic acids such as (meth)acrylic acid and crotonic acid; ethylenic unsaturated dicarboxylic acids such as fumaric acid, itaconic acid, maleic acid, and citraconic acid, and anhydrides thereof; and 2-carboxyethyl methacrylate.

When the acrylic-based resin is a resin having the structural units (p1) and (p2), in all structural units of the acrylic-based resin, the content of the structural unit (p1) is preferably 40 to 99.9 mass%, more preferably 60 to 99 mass%, and further preferably 70 to 98 mass%, and the content of the structural unit (p2) is preferably 0.1 to 30 mass%, more preferably 0.15 to 20 mass%, further preferably 0.2 to 15 mass%, and still further preferably 0.25 to 10 mass%.

In addition, the above-described acrylic-based resin may have a structural unit derived from another monomer other than the above-described structural units (p1) and (p2) as long as satisfying the contents of the above-described structural units (p1) and (p2).

The another monomer can be selected from monomers that can copolymerize with an acrylic-based monomer, and examples thereof include alkyl (meth)acrylate monomers having an alkyl group having 1 to 3 carbon atoms, such as methyl (meth)acrylate, ethyl (meth)acrylate, and propyl (meth)acrylate; and vinyl-based monomers other than the monomers exemplified as the monomer (p2), such as styrene, α-methylstyrene, vinyl toluene, vinyl formate, vinyl acetate, acrylonitrile, and acrylamide.

The mass-average molecular weight (Mw) of the acrylic-based resin is preferably 250,000 to 1,500,000, more preferably 350,000 to 1,300,000, further preferably 450,000 to 1,100,000, and still further preferably 650,000 to 1,050,000.

### (Urethane-based resin)

The urethane-based resin used in the present invention is not particularly limited as long as it is a polymer having at least one of a urethane bond and a urea bond at a main chain and/or a side chain, and examples thereof include a urethane-based prepolymer (α1) obtained by reacting a polyol (x1) with a polyvalent isocyanate compound (x2) and a urethane-based resin (β1) obtained by further performing a chain extension reaction using a chain extender (x3) with respect to the urethane-based prepolymer (α1).

Among them, a urethane-based resin having a polyoxyalkylene skeleton is preferably contained as the urethane-based resin.

It is to be noted that, in the present invention, the urethane-based resin may be used singly or in combination of two or more kinds thereof.

Examples of the polyol (x1) include polyol compounds such as alkylene diols, polyether type polyols, polyester type polyols, and polycarbonate type polyols, but the polyol (x1) is not particularly limited as long as it is a polyol and may be difunctional diols and trifunctional triols. Among these polyols (x1), diols are preferable from the viewpoint of easy availability, reactivity, and the like.

Examples of the diols include alkanediols such as 1,3-propanediol, 1,4-butanediol, 1,5-pentanediol, neopentyl glycol, 1,6-hexanediol, and 1,7-heptanediol, alkylene glycols such as ethylene glycol, propylene glycol, diethylene glycol, and dipropylene glycol, polyalkylene glycols such as polyethylene glycol, polypropylene glycol, and polybutylene glycol, polyoxyalkylene glycols such as polytetramethylene glycol. It is to be noted that these diols may be used singly or in combination of two or more kinds thereof.

Among these diols, when the reaction with the chain extender (x3) is further performed, glycols having a mass-average molecular weight of 1,000 to 3,000 are preferable from the viewpoint of suppressing gelation in the reaction.

Examples of the polyvalent isocyanate compound (x2) include aromatic polyisocyanates, aliphatic polyisocyanates, and alicyclic polyisocyanates.

Examples of the aromatic polyisocyanates include 1,3-phenylene diisocyanate, 1,4-phenylene diisocyanate, 4,4'-diphenylmethane diisocyanate (MDI), 2,4-tolylene diisocyanate (2,4-TDI), 2,6-tolylene diisocyanate (2,6-TDI), 4,4'-toluidine diisocyanate, 2,4,6-triisocyanate toluene, 1,3,5-triisocyanate benzene, dianisidine diisocyanate, 4,4'-diphenylether diisocyanate, 4,4',4"-triphenylmethane triisocyanate, 1,4-tetramethylxylylene diisocyanate, and 1,3-tetramethylxylylene diisocyanate.

Examples of the aliphatic polyisocyanates include trimethylene diisocyanate, tetramethylene diisocyanate, hexamethylene diisocyanate (HMDI), pentamethylene diisocyanate, 1,2-propylene diisocyanate, 2,3-butylene diisocyanate, 1,3-butylene diisocyanate, dodecamethylene diisocyanate, and 2,4,4-trimethylhexamethylene diisocyanate.

Examples of the alicyclic polyisocyanates include 3-isocyanatomethyl-3,5,5-trimethylcyclohexyl isocyanate (IPDI), 1,3-cyclopentane diisocyanate, 1,3-cyclohexane diisocyanate, 1,4-cyclohexane diisocyanate, methyl-2,4-cyclohexane diisocyanate, methyl-2,6-cyclohexane diisocyanate, 4,4'-methylenebis(cyclohexyl isocyanate), and 1,4-bis(isocyanatomethyl)cyclohexane.

It is to be noted that these polyvalent isocyanate compounds (x2) may be a trimethylolpropane adduct type modified product, a biuret type modified product obtained by a reaction with water, or an isocyanurate type modified product containing an isocyanurate ring, of the above-described polyisocyanates.

Among these polyvalent isocyanate compounds (x2), from the viewpoint of obtaining a urethane-based polymer having excellent physical properties of pressure-sensitive adhesion, one or more selected from the group consisting of 4,4'-diphenylmethane diisocyanate (MDI), 2,4-tolylene diisocyanate (2,4-TDI), 2,6-tolylene diisocyanate (2,6-TDI), hexamethylene diisocyanate (HMDI), 3-isocyanatomethyl-3,5,5-trimethylcyclohexyl isocyanate (IPDI), and modified products thereof are preferable, and from the viewpoint of weatherability, one or more selected from the group consisting of HMDI, IPDI, and modified products thereof are more preferable.

As the chain extender (x3), a compound having two groups of at least either hydroxyl groups or amino groups, or a compound having three or more groups of at least either hydroxyl groups or amino groups is preferable.

As the compound having two groups of at least either hydroxyl groups or amino groups, at least one compound selected from the group consisting of aliphatic diols, aliphatic diamines, alkanolamines, bisphenols, and aromatic diamines is preferable.

Examples of the aliphatic diols include alkanediols such as 1,3-propanediol, 1,4-butanediol, 1,5-pentanediol, neopentyl glycol, 1,6-hexanediol, and 1,7-heptanediol, and alkylene glycols such as ethylene glycol, propylene glycol, diethylene glycol, and dipropylene glycol.

Examples of the aliphatic diamines include ethylenediamine, 1,3-propanediamine, 1,4-butanediamine, 1,5-pentanediamine, and 1,6-hexanediamine.

Examples of the alkanolamines include monoethanolamine, monopropanolamine, and isopropanolamine.

Examples of the bisphenols include bisphenol A.

Examples of the aromatic diamines include diphenylmethanediamine, tolylenediamine, and xylylenediamine.

Examples of the compound having three or more groups of at least either hydroxyl groups or amino groups include polyols such as trimethylolpropane, ditrimethylolpropane, pentaerythritol, and dipentaerythritol, amino alcohols such as 1-amino-2,3-propanediol, 1-methylamino-2,3-propanediol, and N-(2-hydroxypropylethanolamine), and an ethylene oxide or propylene oxide adduct of tetramethylxylylenediamine.

A synthesis method of the urethane-based prepolymer (α1) is not particularly limited, and examples thereof include a method in which the polyol (x1) and the polyvalent isocyanate compound (x2), a catalyst that is added as necessary, and a solvent are put in a reactor, and react with each other.

The catalyst to be used is not particularly limited, and examples thereof include tertiary amine-based compounds, and organic metal-based compounds.

The reaction is preferably performed such that the blending ratio of the component (x1) and the component (x2) is preferably 1.1 to 3.0, and more preferably 1.2 to 2.5, in terms of the molar ratio of NCO groups and OH groups ([NCO groups]/[OH groups]).

In addition, the content of isocyanate groups (NCO%) in the obtained urethane-based prepolymer (α1) is preferably 0.5 to 12 mass%, and more preferably 1 to 4 mass%, in terms of a value measured in conformity with JIS K 1603-1.

A synthesis method of the urethane-based polymer (β1) obtained by further performing the chain extension reaction using the chain extender (x3) with respect to the above-described urethane-based prepolymer (α1) is not particularly limited, and examples thereof include the following methods:
- a method in which a solution of the urethane-based prepolymer (α1) is put in a reactor, the chain extender (x3) is delivered by drops into the reactor, and the mixture is made to react with each other;
- a method in which the chain extender (x3) is put in a reactor, a solution of the urethane-based prepolymer (α1) is delivered by drops thereinto, and the mixture is made to react with each other; and
- a method in which a solution obtained by diluting the urethane-based prepolymer (α1) with a solvent is put in a reactor, a predetermined amount of the chain extender is collectively added thereto, and the mixture is made to react with each other.

It is to be noted that, in order to terminate the chain extension reaction, a chain terminating agent such as a compound having only one active hydrogen capable of reacting with the isocyanate groups and a compound having only one amino group may be used.

Examples of the compound having only one active hydrogen capable of reacting with the isocyanate groups include monool compounds such as methanol and ethanol.

Examples of the compound having only one amino group include diethylamine and morpholine.

### (Tackifier)

In the resin composition forming the resin part (A) used in the present invention, from the viewpoint of improving pressure-sensitive adhesive force of the sealing sheet, the resin composition forming the resin part (A) can further contain a tackifier.

Specific examples of the tackifier include a tackifier described in a resin composition forming the resin part (B) described below.

The softening point of the tackifier that can be used together with the resin composition forming the resin part (A) is preferably 60 to 170°C, more preferably 65 to 160°C, and further preferably 70 to 150°C. It is to be noted that the "softening point" is a value measured in conformity with JIS K 2207.

### (Cross-linking agent)

When the above-described resin having a functional group, such as the above-described acrylic-based resin having the structural unit (p2) derived from the functional group-containing monomer (p2), is contained in the resin composition forming the resin part (A), it is preferable that the resin composition forming the resin part (A) further contain a cross-linking agent. The cross-linking agent reacts with the functional group of the above-described resin to cross-link between the resins.

Examples of the cross-linking agent include isocyanate-based cross-linking agents such as tolylene diisocyanate, hexamethylene diisocyanate, and adducts thereof; epoxy-based cross-linking agents such as ethylene glycol glycidyl ether; aziridine-based cross-linking agents such as hexa[1-(2-methyl)-aziridinyl]triphosphatriazine; and chelate-based cross-linking agents such as an aluminum chelate. These cross-linking agents may be used singly or in combination of two or more kinds thereof.

Among them, from the viewpoint of increasing cohesive force to improve the interface adhesive force and from the viewpoint of easy availability, isocyanate-based cross-linking agents are preferable.

The amount of the cross-linking agent blended is arbitrarily adjusted depending on the number of functional groups in the structure of the resin contained in the resin composition forming the resin part (A), and from the viewpoint of facilitating the cross-linking reaction, it is preferably 0.01 to 10 parts by mass, more preferably 0.03 to 7 parts by mass, and further preferably 0.05 to 4 parts by mass with respect to 100 parts by mass of the above-described resin having a functional group, such as a (meth)acrylic acid ester resin.

### (Other additives)

The resin composition forming the resin part (A) may contain other additives depending on the intended use of the sealing sheet as long as not impairing the effects of the present invention. Examples of the other additives include an ultraviolet absorbing agent, an antioxidizing agent, a softener (plasticizer), a filler, an anti-rust agent, a pigment, and a dye.

When these additives are blended, the amount of the additives blended is preferably 0.01 to 6 parts by mass with respect to 100 parts by mass of the resin composition forming the resin part (A).

### <Resin composition forming resin part (B)>

The water vapor transmission rate measured in conformity with JIS K 7129 of the resin part (B) used in the present invention is 15 g/m²/day or less.

When the water vapor transmission rate exceeds 15 g/m²/day, moisture intrusion into the sealing sheet having the resin part (B) cannot be effectively prevented under a heating and humidifying condition in long-term use. From the same viewpoint, the water vapor transmission rate of the resin composition forming the resin part (B) is preferably 14 g/m²/day or less, more preferably 13 g/m²/day or less, further preferably 10 g/m²/day or less, still further preferably 5 g/m²/day or less, and still further preferably 4 g/m²/day or less.

It is to be noted that the value of the water vapor transmission rate indicates a value measured by a method described in Examples.

The resin composition forming the resin part (B) used in the present invention is preferably a resin composition containing one or more resins selected from the group consisting of a butyl rubber, a polyisobutylene-based resin, a styrene-based copolymer, a polyisoprene-based resin, a polybutadiene-based resin, and a polybutene-based resin.

Among them, a polyisobutylene-based resin is more preferably contained.

### (Polyisobutylene-based resin)

The structure of the polyisobutylene-based resin is a resin having a polyisobutylene skeleton at the main chain or the side chain, and a resin having the following structural unit (b).

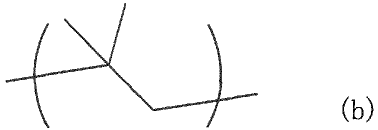

Examples of the polyisobutylene-based resin include polyisobutylene that is a homopolymer of isobutylene, a copolymer of isobutylene and isoprene, a copolymer of isobutylene and n-butene, a copolymer of isobutylene and butadiene, and halogenated butyl rubbers obtained by bromizing or chlorinating these homopolymer or copolymers. These resins may be used singly or in combination of two or more kinds thereof.

It is to be noted that, when the polyisobutylene-based resin is a copolymer, the structural unit composed of isobutylene shall be most contained among all monomer components.

Among them, from the viewpoint of high durability and high weatherability, and decreasing the water vapor transmission rate, one having the structural unit composed of isobutylene, which has a tight molecular structure when being polymerized and does not leave a polymerizable double bond at the main chain and the side chain, is preferable.

The content of the structural unit composed of isobutylene is preferably 80 to 100 mass%, more preferably 90 to 100 mass%, and further preferably 100 mass% with respect to all structural units contained in the resin.

Examples of a synthesis method of the polyisobutylene-based resin include a method in which a monomer component such as isobutylene is polymerized in the presence of a Lewis acid catalyst such as aluminum chloride and boron trifluoride. In addition, as the polyisobutylene-based resin, not only synthetic compounds but also commercial products can be used.

Examples of the commercial products include Vistanex (manufactured by Exxon Chemical Co.), Hycar (manufactured by Goodrich), and Oppanol (manufactured by BASF).

As one mode of the resin composition forming the resin part (B), a polyisobutylene-based resin having a mass-average molecular weight of 270,000 to 600,000 (b-1) (hereinafter, also referred to as "polyisobutylene-based resin (b-1)" or "resin (b-1)") and a polyisobutylene-based resin having a mass-average molecular weight of 50,000 to 250,000 (b-2) (hereinafter, also referred to as "polyisobutylene-based resin (b-2)" or "resin (b-2)") are preferably contained.

### [Polyisobutylene-based resin (b-1)]

The above-described polyisobutylene-based resin (b-1) is a polyisobutylene-based resin having a mass-average molecular weight of 270,000 to 600,000. The polyisobutylene-based resin (b-1) having a specific mass-average molecular weight is contained, so that the durability and weatherability of the sealing sheet can be improved and the water vapor transmission rate can be decreased.

From the viewpoint of improving the cohesive force of the resin composition and decreasing the water vapor transmission rate, the mass-average molecular weight of the resin (b-1) is 270,000 to 600,000, preferably 270,000 to 480,000, more preferably 300,000 to 450,000, further preferably 320,000 to 400,000, and still further preferably 340,000 to 370,000.

When the mass-average molecular weight of the resin (b-1) is 270,000 or more, the cohesive force of the obtained resin composition can be sufficiently improved, and the pressure-sensitive adhesive force of the sealing sheet using the resin composition and the suppressing effect on moisture intrusion can be improved. In addition, concern about contamination of the adherend can be resolved. Basically, when the mass-average molecular weight becomes higher, the water vapor transmission rate can be more decreased and the retention force can be more improved.

In contrast, when the mass-average molecular weight of the resin (b-1) is 600,000 or less, an adverse effect of lowering flexibility and fluidity due to too high cohesive force of the obtained resin composition can be avoided, and the wettability with the adherend of the resin layer formed from the resin composition becomes good. Furthermore, the solubility in a solvent when making a solution from the resin composition becomes good.

### [Polyisobutylene-based resin (b-2)]

The above-described polyisobutylene-based resin (b-2) is a polyisobutylene-based resin having a mass-average molecular weight of 50,000 to 250,000. The polyisobutylene-based resin (b-2) having a specific mass-average molecular weight is contained, so that excellent pressure-sensitive adhesive force can be imparted independent of the type of the adherend and a balance between the pressure-sensitive adhesive force and the retention force can be improved.

The structure of the polyisobutylene-based resin (b-2) is a resin having a polyisobutylene skeleton at the main chain or the side chain as is the case with the resin (b-1), and a resin having the above-described structural unit (b).

Examples of the resin (b-2) include one exemplified in the above-described resin (b-1), and from the viewpoint of high durability and high weatherability, and decreasing the water vapor transmission rate, one having the structural unit composed of isobutylene, which has a tight molecular structure when being polymerized and does not leave a polymerizable double bond at the main chain and the side chain, is preferable.

The content of the structural unit composed of isobutylene is preferably 80 to 100 mass%, more preferably 90 to 100 mass%, and further preferably 100 mass% with respect to all structural units contained in the resin (b-2).

It is to be noted that the resin (b-2) may be used singly or in combination of two or more kinds thereof. In addition, the synthesis method of the resin (b-2) and the usable commercial products are also the same as those in the above-described resin (b-1).

The resin (b-2) is well compatible with the resin (b-1) to moderately plasticize the resin (b-1), so that the wettability against the adherend can be increased and the physical properties of pressure-sensitive adhesion, the flexibility, the retention force, and the like can be improved.

From the viewpoint of being well compatible with the resin (b-1) to moderately plasticize the resin (b-1) and reducing the effects on other physical properties such as the water vapor transmission rate, the mass-average molecular weight of the resin (b-2) is 50,000 to 250,000, preferably 100,000 to 250,000, more preferably 120,000 to 230,000, further preferably 150,000 to 220,000, and still further preferably 180,000 to 210,000.

When the mass-average molecular weight of the resin (b-2) is 50,000 or more, in the resin layer formed from the obtained resin composition, an adverse effect of contamination of the adherend due to separation of the resin (b-2) as a low-molecular component and precipitation of the resin (b-2) on the surface of the resin layer can be avoided. Furthermore, effects on physical properties, such as an increase in the amount of outgas generated, which is generated under high temperature, can also be avoided.

In contrast, when the mass-average molecular weight of the resin (b-2) is 250,000 or less, the resin (b-2) can be sufficiently plasticized, and the wettability with the adherend of the resin layer formed from the obtained resin composition becomes good.

From the viewpoint of a balance among the pressure-sensitive adhesive force, the retention force, and the decreasing effect of the water vapor transmission rate, the content of the polyisobutylene-based resin (b-2) in the resin composition forming the resin part (B) is 5 to 55 parts by mass, preferably 7 to 40 parts by mass, more preferably 8 to 30 parts by mass, and further preferably 9 to 20 parts by mass with respect to 100 parts by mass of the resin (b-1).

When the content is 5 parts by mass or more, the resin (b-1) can be sufficiently plasticized, the wettability with the adherend can be sufficiently obtained, and the pressure-sensitive adhesive force is excellent. In contrast, when the content is 55 parts by mass or less, the pressure-sensitive adhesive force and the retention force can be maintained without decreasing the cohesive force, and the durability with respect to ultraviolet irradiation is also excellent.

As another mode of the resin composition forming the resin part (B), the resin composition forming the resin part (B) preferably contains a polyisobutylene-based resin having a mass-average molecular weight of 20,000 or more (b-3) (hereinafter, also referred to as "polyisobutylene-based resin (b-3)" or "resin (b-3)"), and one or more styrene-based copolymers selected from the group consisting of a styrene-butadiene-styrene triblock copolymer (SBS), a styrene-(ethylene-co-butylene)-styrene triblock copolymer (SEBS), a styrene-isobutylene diblock copolymer (SIB), and a styrene-isobutylene-styrene triblock copolymer (SIBS), (b-4) (hereinafter, also referred to as "styrene-based copolymer (b-4)" or "resin (b-4)").

### [Polyisobutylene-based resin (b-3)]

The above-described polyisobutylene-based resin (b-3) is a polyisobutylene-based resin having a mass-average molecular weight of 20,000 or more.

When the mass-average molecular weight of the resin (b-3) is 20,000 or more, the cohesive force of the resin composition is sufficiently obtained and the pressure-sensitive adherence can be sufficiently improved. In addition, when the sealing sheet using the resin composition is used, the suppressing effect on moisture intrusion of the sealing sheet is also sufficient. Furthermore, the contamination of the adherend can be prevented.

It is to be noted that, basically, when the mass-average molecular weight of the resin (b-3) becomes higher, the pressure-sensitive adhesive force of the sealing sheet using the obtained resin composition is more improved and the suppressing effect on moisture intrusion when the sealing sheet is used for sealing also tends to be more improved.

Although the mass-average molecular weight of the resin (b-3) is 20,000 or more, from the above-described viewpoint and from the viewpoint of the wettability against an adherend and the solubility against a solvent, it is preferably 30,000 to 1,000,000, more preferably 50,000 to 800,000, further preferably 70,000 to 600,000, and still further preferably 140,000 to 450,000.

In addition, from the viewpoint of improving the pressure-sensitive adhesive force, durability, weatherability, and wettability of the sealing sheet using the obtained resin composition, the resin (b-3) is preferably used in combination with the above-described polyisobutylene-based resin (b-1) having a high mass-average molecular weight and the above-described polyisobutylene-based resin (b-2) having a low mass-average molecular weight.

From the viewpoint of improving the pressure-sensitive adhesive force and making the suppressing effect on moisture intrusion good, the amount of the polyisobutylene-based resin with respect to 100 parts by mass of the resin composition forming the resin part (B) of the present invention is preferably 20 to 95 parts by mass, more preferably 25 to 90 parts by mass, and further preferably 30 to 85 parts by mass.

### (Styrene-Based Copolymer (b-4))

The resin composition forming the resin part (B) used in the present invention preferably contains one or more styrene-based copolymers (b-4) selected from a styrene-butadiene-styrene triblock copolymer (SBS), a styrene-(ethylene-co-butylene)-styrene triblock copolymer (SEBS), a styrene-isobutylene diblock copolymer (SIB), and a styrene-isobutylene-styrene triblock copolymer (SIBS).

By containing one or more styrene-based copolymers selected from the above in the resin composition forming the resin part (B), as the component (b-4), the suppressing effect on moisture intrusion of the sealing sheet using the resin composition becomes good, and the adhesive force of the sealing sheet can be improved.

Among the resins (b-4), from the viewpoint of improving the pressure-sensitive adhesive force of the sealing sheet using the resin composition, one or more selected from the group consisting of SBS and SEBS are preferable. Furthermore, from the viewpoint of improving the suppressing effect on moisture intrusion of the sealing sheet, one or more selected from SIB and SIBS are preferable.

From the viewpoint of making the suppressing effect on moisture intrusion of the sealing sheet using the obtained resin composition good and improving the adhesive force of the sealing sheet, the mass-average molecular weight (Mw) of the resin (b-4) is preferably 10,000 to 400,000, more preferably 20,000 to 300,000, further preferably 25,000 to 200,000, and still further preferably 30,000 to 90,000.

When Mw of the component (b-4) is 10,000 or more, the adhesive force of the sealing sheet using the obtained resin composition can be improved. In contrast, when Mw of the component (b-4) is 400,000 or less, the value of the water vapor transmission rate of the resin layer formed from the obtained resin composition can be reduced and the suppressing effect on moisture intrusion of the sealing sheet can be improved, while the adhesive force of the sealing sheet using the obtained resin composition is kept good.

From the viewpoint of improving the suppressing effect on moisture intrusion of the sealing sheet when the sealing sheet using the resin composition is used for sealing an organic EL element or the like and the viewpoint of improving the adhesive force of the sealing sheet, the softening point of the resin (b-4) is preferably 80 to 200°C, more preferably 90 to 160°C, further preferably 100 to 140°C, and still further preferably 105 to 135°C.

The ratio of styrene contained in the styrene-based copolymer of the resin (b-4) is preferably 5 to 50 mass%, more preferably 10 to 40 mass%, and further preferably 15 to 35 mass%.

The ratio of the content of the resin (b-3) to the content of the resin (b-4) [(b-3)/(b-4)] is preferably 40/60 to 95/5, more preferably 45/55 to 92/8, further preferably 50/50 to 90/10, still further preferably 55/45 to 88/12, still further preferably 60/40 to 85/15, and still further preferably 65/35 to 82/15.

When the ratio is within the above-described range, the value of the water vapor transmission rate of the resin layer formed from the resin composition can be reduced and the suppressing effect on moisture intrusion of the sealing sheet becomes good, while the adhesive force of the sealing sheet using the obtained resin composition is improved.

From the viewpoint of improving the compatibility and the suppressing effect on moisture intrusion, the content of the resin (b-4) with respect to the total amount of the resin composition forming the resin part (B) used in the present invention is preferably 2 to 60 mass%, more preferably 4 to 55 mass%, further preferably 6 to 50 mass%, and still further preferably 8 to 47 mass%.

### (Tackifier)

The resin composition forming the resin part (B) used in the present invention further preferably contains a tackifier having a softening point of 135°C or less.

The tackifier indicates a compound having a molecular weight in the oligomer region, which can be mixed with the resin composition forming the resin part (B) and other resin components and has a function to improve the adhesive performance of these resin components. The number average molecular weight of the tackifier is usually 100 to 18,000, and preferably 100 to 10,000.

The softening point of the tackifier used in the present invention is preferably 135°C or less.

The softening point of the tackifier of 135°C or less is preferable because the pressure-sensitive adherence of the resin composition containing the resin part (B) can be prevented from being significantly decreased. In addition, zipping generated when peeling off the sealing sheet using the resin composition can be prevented.

The softening point of the tackifier is preferably 132°C or less, more preferably 128°C or less, further preferably 120°C or less, still further preferably 110°C or less, and still further preferably 105°C or less from the above-described viewpoint.

In contrast, from the viewpoint of improving the cohesive force of the obtained resin composition and obtaining the resin composition that exhibits an excellent adhesive property, the softening point of the tackifier is preferably 60°C or more, more preferably 70°C or more, further preferably 80°C or more, and still further preferably 90°C or more.

In the present invention, two or more kinds of tackifiers having different softening points may be combined. When a plurality of tackifiers is used, the weighted average of the softening points of these tackifiers only has to be within the above-described range. Therefore, in the present invention, as long as the weighted average of the softening points of the plurality of tackifiers is 135°C or less (within the above-described range), a tackifier having a softening point more than 135°C may be contained in the resin composition forming the resin part (B).

The content of the tackifier having a softening point more than 135°C is preferably 10 mass% or less, more preferably 4 mass% or less, further preferably 1 mass% or less, and still further preferably 0.01 mass% or less, with respect to the total amount of the tackifiers contained in the resin composition forming the resin part (B).

Specific examples of the tackifier preferably include those having a softening point of 135°C or less, among aliphatic hydrocarbon resins, resins derived from organism, such as rosin-based resins such as a rosin resin, a rosin phenol resin, and a rosin ester resin; hydrogenated rosin-based resins obtained by hydrogenating these rosin-based resins; terpene-based resins such as a terpene-based resin, a terpene phenol-based resin, and an aromatic modified terpene-based resin; and hydrogenated terpene-based resins obtained by hydrogenating these terpene-based resins; and resins derived from petroleum, such as C5-based petroleum resins and hydrogenated petroleum resins of the C5-based petroleum resins; and C9-based petroleum resins obtained by copolymerizing C9 fractions and hydrogenated petroleum resins of the C9-based petroleum resins; and the like.

The above-described tackifiers may be used singly or in combination of two or more kinds thereof.

Here, a "C5 fractions" indicate unsaturated hydrocarbons having 5 carbon atoms, such as pentene, isoprene, piperine, and 1,3-pentadiene, generated by thermal decomposition of petroleum naphtha, and the "C5-based petroleum resins" indicate resins obtained by copolymerizing the C5 fractions and containing the C5 fractions as the main component (containing at least 20 mass% or more).

In addition, the above-described "C9 fractions" indicate unsaturated hydrocarbons having 9 carbon atoms, such as indene, vinyl toluene, and α or β-methylstyrene, generated by thermal decomposition of petroleum naphtha, and the "C9-based petroleum resins" indicate resins obtained by copolymerizing the C9 fractions and containing the C9 fractions as the main component (containing at least 20 mass% or more).

It is to be noted that the above-described "hydrogenated resins" include not only perhydrogenated resins that are fully hydrogenated but also partially hydrogenated resins that are partially hydrogenated.

The content of the tackifier is preferably 5 to 60 parts by mass, more preferably 8 to 50 parts by mass, further preferably 10 to 45 parts by mass, and still further preferably 15 to 42 parts by mass, with respect to 100 parts by mass of the sum of resin composition forming the resin part (B).

When the content of the tackifier is 5 parts by mass or more, the wettability with the adherend can be sufficiently obtained to improve the pressure-sensitive adhesive force in the resin layer formed from the obtained resin composition, and furthermore, the sealing sheet which has a small value of the water vapor transmission rate of the resin layer and excels in the suppressing effect on moisture intrusion can be obtained.

In contrast, when the content of the tackifier is 60 parts by mass or less, in the resin layer formed from the obtained resin composition, excellent adhesive force can be exhibited regardless of the adherend, and the occurrence of zipping can be suppressed. Furthermore, the sealing sheet which has a small value of the water vapor transmission rate of the resin layer and excels in the suppressing effect on moisture intrusion can be obtained.

### (Other Additives)

The resin composition forming the resin part (B) of the present invention may further contain other additives as long as not impairing the effects of the present invention.

Examples of the other additives include the above-described other additives described in the resin composition forming the resin part (A). The other additives may be used singly or in combination of two or more kinds thereof.

### <Support>

The support is not particularly limited as long as it is a sheet shape, and is arbitrarily selected depending on the intended use of the sealing sheet of the present invention. Examples thereof include various paper such as high-quality paper, art paper, coated paper, glassine paper, and laminated paper obtained by laminating a thermoplastic resin such as polyethylene on these paper substrates, various synthetic paper, metal foil such as aluminum foil, copper foil, and iron foil, a porous material such as non-woven fabric, a plastic film or sheet made of polyolefin resins such as a polyethylene resin and a polypropylene resin, polyester resins such as a polybutylene terephthalate resin and a polyethylene terephthalate resin, an acetate resin, an ABS resin, a polystyrene resin, a vinyl chloride resin and the like, and a plastic film or sheet made of a mixture or a laminate of these resins. A sheet-shaped substrate such as a plastic film or sheet may be unstretched, or stretched in a uniaxial direction or in a biaxial direction, such as longitudinal or transverse.

Although it does not matter whether the support to be used is colored, when the support to be used is used as a sealing member, it is preferably one through which ultraviolet rays pass sufficiently, and furthermore, is more preferably colorless and transparent in the visible light region.

In addition, in the sealing sheet of the present invention, a gas barrier film having a substrate for gas barrier and a gas barrier layer may be used as a support in place of the support made of the above-described materials. The details about the gas barrier film are as described below.

The thickness of the support is not particularly limited, but from the viewpoint of ease of handling, it is preferably 10 to 250 µm, more preferably 15 to 200 µm, and further preferably 20 to 150 µm.

It is to be noted that the support may further contain an ultraviolet absorbing agent, a light stabilizing agent, an antioxidizing agent, an antistatic agent, a slip agent, an antiblocking agent, a coloring agent and the like.

When the support is a plastic-based material, from the viewpoint of improving an adhesion property of the support with the resin layer, the surface of the support is preferably subjected to surface treatment such as an oxidation method and a roughening method, as necessary.

The oxidation method is not particularly limited, and examples thereof include a corona discharge treatment method, a plasma treatment method, chromium acid oxidation (wet type), flame treatment, hot-air treatment, and ozone/ultraviolet irradiation treatment. Moreover, the roughening method is not particularly limited, and examples thereof include a sandblast method and a solvent treatment method.

The surface treatment is arbitrarily selected depending on the kind of the support, and from the viewpoint of an improving effect of an adhesion property with the resin layer and handleability, a corona discharge treatment method is preferable. Furthermore, primer treatment can also be performed.

A stopping material layer may be optionally provided between the support and the resin layer depending on the kind of the support. The stopping material layer is provided so as to further improve the adhesion property between the support and the resin layer or to impart a stiffness property when the support is too flexible, in addition to the prevention of penetration of the resin composition or the solution of the resin composition into the support.

Such a stopping material layer is not particularly limited, and examples thereof include a layer made of a styrene-butadiene copolymer, an acrylic-based resin, a polyester-based resin, a polyurethane-based resin, a polystyrene-based resin or the like as a main component (containing at least 20 mass% or more), to which a filler, such as clay, silica, calcium carbonate, titanium oxide, and zinc oxide, is added as needed.

The thickness of the stopping material layer is not particularly limited, and is usually 0.1 to 30 µm.

### (Gas Barrier Film)

As the support of the sealing sheet of the present invention, it is preferable to use a gas barrier film having a substrate for gas barrier and a gas barrier layer. The gas barrier film only has to have the gas barrier layer on at least one surface side of the substrate for a gas barrier film.

In addition, the gas barrier film preferably includes the single-layer or multiple-layer gas barrier layer composed of one or more selected from the group consisting of an inorganic layer, an organic layer, and a metal layer.

### [Substrate for Gas barrier Film]

The substrate for a gas barrier film is not particularly limited, and examples thereof include a sheet and the like made of polyolefins such as polyethylene and polypropylene, polyesters such as polyethylene terephthalate and polybutylene terephthalate, polyamides such as polyimide, polyamideimide, a wholly aromatic polyamide, Nylon 6, Nylon 66, and a nylon copolymer, cycloolefin-based polymers such as a norbornene-based polymer, a monocyclic cyclic olefin-based polymer, a cyclic conjugated diene-based polymer, a vinyl-alicyclic hydrocarbon polymer, and hydrogenated products thereof, and resins such as polyphenylene ether, polyether ketone, polyether ether ketone, polycarbonate, polysulfone, polyether sulfone, polyphenylene sulfide, and polyarylate.

Among them, from the viewpoint of excellent transparency and general versatility, polyesters, polyamides, or cycloolefin-based polymers are preferable, and polyesters or cycloolefin-based polymers are more preferable.

The thickness of the substrate for a gas barrier film is not particularly limited, but from the viewpoint of ease of handling, it is preferably 2 to 200 µm, more preferably 10 to 150 µm, and further preferably 20 to 100 µm.

### (Gas Barrier Layer)

Although a material for forming the gas barrier layer is not particularly limited as long as it prevents permeation of oxygen and water vapor, the inorganic layer is preferably formed from an inorganic material containing one or more selected from the group consisting of diamond-like glass, diamond-like carbon, silicon oxide, silicon nitride, and silicon carbide, when the inorganic layer is included in the gas barrier layer. When the organic layer is included in the gas barrier layer, the organic layer is preferably formed from an organic material containing one or more selected from the group consisting of polyimide, polyamide, polyamideimide, polyphenylene ether, polyether ketone, and polyether ether ketone.

In addition, the gas barrier property may be improved by performing surface modification such as plasma ion injection treatment and vacuum ultraviolet irradiation treatment with respect to the inorganic layer or the organic layer formed on the substrate for a gas barrier film. When the metal layer is included in the gas barrier layer, the metal layer is preferably formed from one or more selected from the group consisting of aluminum, copper, tin, and zinc. A method for forming the gas barrier layer may be arbitrarily selected depending on the material to be used. For example, examples thereof include a method in which the above-described material of the gas barrier layer is formed on the substrate for a gas barrier film by a vapor deposition method, a sputtering method, an ion plating method, a thermal CVD method, a plasma CVD method, or the like, and a method in which a solution obtained by dissolving the above-described material of the gas barrier layer in an organic solvent is applied to the substrate for a gas barrier film.

The thickness of the gas barrier layer is preferably 10 to 2,000 nm, and more preferably 50 to 500 nm.

When the gas barrier layer is formed on the substrate for a gas barrier film, an anchor layer is preferably formed on the substrate, and the thickness of the anchor layer is preferably 1 to 2,000 nm, and more preferably 1 to 1,000 nm. Examples of a material constituting the anchor layer include an acrylic resin and a polyester resin.

### <Release Sheet>

As the release sheet, a release sheet whose both surfaces are subjected to peeling treatment and a release sheet whose one surface is subjected to peeling treatment are used, and examples thereof include one in which a peeling agent is applied on a substrate for a release sheet.

Examples of the substrate for a release sheet include paper substrates such as glassine paper, coated paper, and high-quality paper, laminated paper obtained by laminating a thermoplastic resin such as polyethylene on these paper substrates, or plastic films such as polyester resin films made of a polyethylene terephthalate resin, a polybutylene terephthalate resin, a polyethylene naphthalate resin and the like, and polyolefin resin films made of a polypropylene resin, a polyethylene resin and the like.

Examples of the peeling agent include rubber-based elastomers such as a silicone-based resin, an olefin-based resin, an isoprene-based resin, and a butadiene-based resin, a long-chain alkyl-based resin, an alkyd-based resin, and a fluorine-based resin.

The thickness of the release sheet is not particularly limited, but it is preferably 20 to 200 µm, and more preferably 25 to 150 µm.

### <Manufacturing Method of Sealing Sheet>

A manufacturing method of the sealing sheet of the present invention is not particularly limited, and the sealing sheet can be manufactured by a known method. Examples thereof include a method in which the solution of the resin composition, obtained by adding an organic solvent to the above-described a resin composition, is applied by a known applying method to manufacture a sealing sheet.

An organic solvent such as methyl ethyl ketone, acetone, ethyl acetate, tetrahydrofuran, dioxane, cyclohexane, n-hexane, toluene, xylene, n-propanol, or isopropanol may be blended into the resin composition forming the resin part (A) and the resin composition forming the resin part (B) used in the present invention to give a solution of the resin compositions.

Each of the solid content of the solution of the resin composition forming the resin part (A) and the solid content of the solution of the resin composition forming the resin part (B) when the organic solvent is blended are preferably 10 to 60 mass%, more preferably 10 to 45 mass%, and further preferably 15 to 30 mass%. When the solid content is 10 mass% or more, the amount of the organic solvent used is sufficient, and when it is 60 mass% or less, the solution has a moderate viscosity and excellent application workability.

Examples of the applying method include a screen printing method, a spin coat method, a spray coat method, a bar coat method, a knife coat method, a roll coat method, a roll knife coat method, a blade coat method, a die coat method, and a gravure coat method.

### <Intended use of sealing sheet>

The sealing sheet of the present invention has excellent interface adhesive force and interface adherence with an adherend, and in particular, excels in the suppressing effect on moisture intrusion.

Therefore, the sealing sheet of the present invention is suitable as a sealing member of an organic EL element or the like, and when the sealing sheet of the present invention is used as a sealing member, a decrease in adherence between the substrate (adherend) and the sealing sheet, of the sealing sheet, due to moisture intrusion and heat generated during driving of the organic EL element can be suppressed, and property degradation of the organic EL element can be thus suppressed.

Specifically, the sealing sheet of the present invention can be used as a sealing member for electronic devices, for example, organic devices such as an organic transistor, an organic memory, and an organic EL element; liquid crystal displays; electronic paper; thin film transistors; electrochromic devices; electrochemical light-emitting devices; touch panels; solar batteries; thermoelectric conversion devices; piezoelectric conversion devices; electric storage devices; and the like.

Among them, the sealing sheet of the present invention is preferably used for sealing an organic EL element.

### [Sealing structure]

A sealing structure of the present invention is a sealing structure obtained by sealing an object to be sealed, which is provided on a substrate (adherend), with the sealing sheet of the present invention.

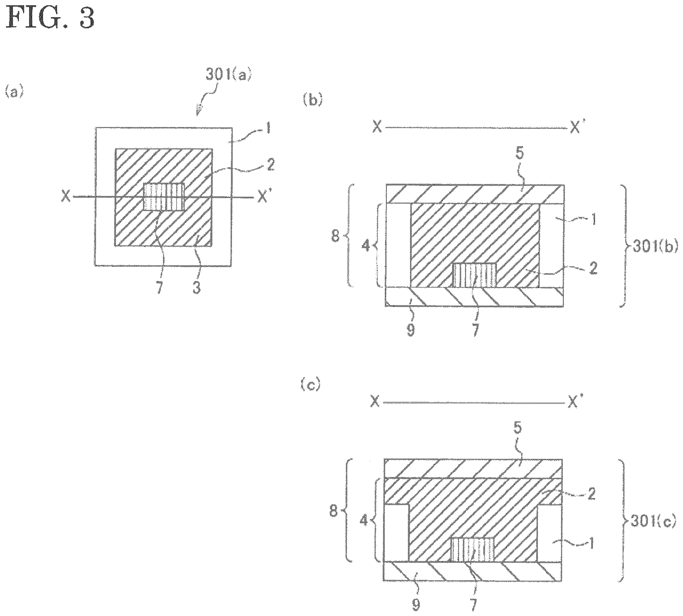

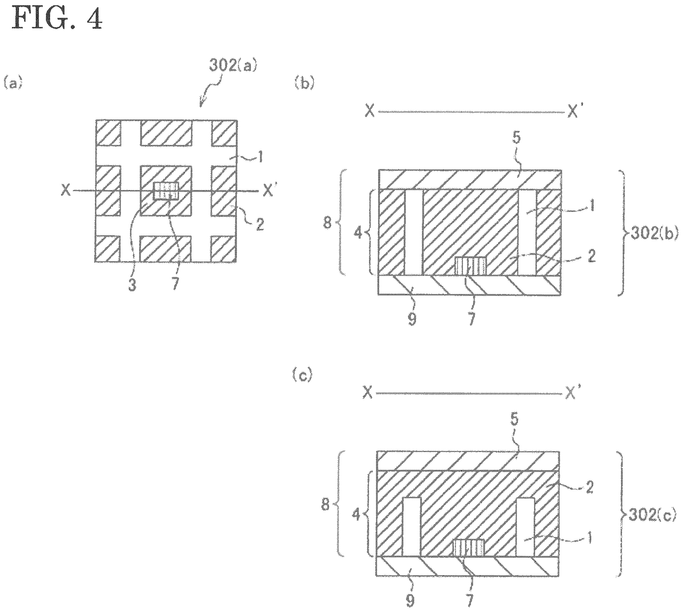

Examples of the sealing structure according to the embodiment, which is sealed with the sealing sheet of the present invention, will be described using Fig. 3 and Fig. 4, but the sealing structure of the present invention is not limited to the following examples as long as the effects of the present invention are exhibited. It is to be noted that each of plan views in Fig. 3 and Fig. 4 is a plan view illustrating a part of the sealing structure from which the illustration of a support 5 and a substrate (adherend) 9 is omitted for the purpose of description.

In one mode illustrated in the plan view of Fig. 3(a), in a sealing structure 301(a), the resin part (A) 1 is present on an outer edge of the resin part (B) 2, the resin part (A) 1 forms a closed region 3, and the resin part (B) 2 is present in the closed region 3. An object 7 to be sealed is arranged in the closed region 3.

One mode illustrated in the cross-sectional view of Fig. 3(b) illustrates one example that the cross-sectional view taken along X-X' of Fig. 3(a) can take. In the cross-sectional view of Fig. 3(b), a sealing structure 301(b) has a structure in which a sealing sheet 8 composed of a resin layer 4 and a support 5 is provided on a substrate (adherend) 9, the object 7 to be sealed is arranged on the substrate (adherend) 9, and the resin part (A) 1 is present at both ends of the resin part (B) 2 that seals the object 7 to be sealed. The resin part (A) 1 is in contact with both the substrate (adherend) 9 and the support 5.

In addition, one mode illustrated in the cross-sectional view of Fig. 3(c) illustrates one example that the cross-sectional view taken along X-X' of Fig. 3(a) can take. In the cross-sectional view of Fig. 3(c), a sealing structure 301(c) has a structure in which a sealing sheet 8 composed of a resin layer 4 and a support 5 is provided on a substrate (adherend) 9, the object 7 to be sealed is arranged on the substrate (adherend) 9, and the resin part (A) 1 is present at both ends of the resin part (B) 2 that seals the object 7 to be sealed. The resin part (A) 1 is in contact with only the substrate (adherend) 9. Only the resin part (B) 2 that seals the object 7 to be sealed is in contact with the side of the support 5.

In one mode illustrated in Fig. 4(a), a resin layer 302(a) of a sealing structure has a structure in which a sealing sheet 8 composed of a resin layer 4 and a support 5 is provided on a substrate (adherend) 9, the resin part (A) 1 and the resin part (B) 2 are arranged in a lattice pattern, the resin part (A) 1 forms a closed region 3, and the resin part (B) 2 is present in the closed region 3. An object 7 to be sealed is arranged in the closed region 3.

One mode illustrated in the cross-sectional view of Fig. 4(b) illustrates one example that the cross-sectional view taken along X-X' of Fig. 4(a) can take. In the cross-sectional view of Fig. 4(a), a sealing structure 302(b) has a structure in which a sealing sheet 8 composed of a resin layer 4 and a support 5 is provided on a substrate (adherend) 9, the object 7 to be sealed is arranged on the substrate (adherend) 9, the object 7 to be sealed is sealed with the resin part (B) 2, and, on the surface of the substrate (adherend) 9, which is in contact with the object 7 to be sealed, the resin part (B) 2, the resin part (A) 1, and the resin part (B) 2 are present in this order on a straight line toward an outer edge of the substrate (adherend) 9 from an outer edge of the object 7 to be sealed. The resin part (A) 1 is in contact with both the substrate (adherend) 9 and the support 5.

In addition, one mode illustrated in the cross-sectional view of Fig. 4(c) illustrates one example that the cross-sectional view taken along X-X' of Fig. 4(a) can take. In the cross-sectional view of Fig. 4(c), a sealing structure 302(c) has a structure in which a sealing sheet 8 composed of a resin layer 4 and a support 5 is provided on a substrate (adherend) 9, the object 7 to be sealed is arranged on the substrate (adherend) 9, the object 7 to be sealed is sealed with the resin part (B) 2, and, on the surface of the substrate (adherend) 9, which is in contact with the object 7 to be sealed, the resin part (B) 2, the resin part (A) 1, and the resin part (B) 2 are present in this order on a straight line toward an outer edge of the substrate (adherend) 9 from an outer edge of the object 7 to be sealed. The resin part (A) 1 is in contact with only the substrate (adherend) 9. Only the resin part (B) 2 that seals the object 7 to be sealed is in contact with the side of the support 5.

When the sealing structure of the present invention having the configuration is used, generally, the object 7 to be sealed is placed on the substrate (adherend) 9 that is the opposite side of the support 5, and thus, the resin part (A) 1 and the resin part (B) 2 are present on the side of the substrate (adherend) 9. Therefore, a decrease in adherence between the resin part (B) 2 and the substrate (adherend) 9 is particularly suppressed and the interface adherence is more improved by the resin part (A) 1, and thus, moisture that intrudes between the substrate (adherend) 9 and the resin layer 4 can be effectively prevented, and the sealing structure that excels in durability under heating and humidifying can be obtained.

### <Substrate (adherend)>

As the substrate (adherend) of the sealing structure of the present invention, for example, a glass plate or a gas barrier film is used. As the glass plate, a glass plate that is conventionally used for an electronic device can be used. As the gas barrier film, a film that is the same as the above-described gas barrier film described in the sealing sheet can be used.

The thickness of the substrate (adherend) is preferably 1 to 300 µm, and more preferably 20 to 200 µm.

The water vapor transmission rate measured in conformity with JIS K 7129 under conditions of 40°C and 90% RH (relative humidity) of the substrate (adherend) is preferably less than 0.1 g/m²/day, and more preferably 0.01 g/m²/day.

It is to be noted that the water vapor transmission rate of the substrate (adherend) can be measured using a gas transmission rate-measuring apparatus described in Examples described below.

### <Object to be sealed>

The object to be sealed that the sealing structure of the present invention seals is preferably an organic EL element or the like as is the case with that described in the above-described sealing sheet. The sealing structure of the present invention can suppress a decrease in adherence between the sealing sheet and the substrate (adherend) due to moisture intrusion and heat generated during driving of the organic EL element, and can suppress property degradation of the organic EL element.

In the same manner, the object to be sealed is preferably an organic EL display element, a liquid crystal display element, or a solar cell element because the effect of the sealing structure of the present invention is more exerted.

### [Light-emitting device, display device, or solar cell]

A light-emitting device, a display device, or a solar cell having the sealing sheet or the sealing structure of the present invention can suppress a decrease in adherence between the sealing sheet and the substrate (adherend) due to moisture intrusion and heat generated during driving of each element, can suppress property degradation of each element, and thus, excels in durability under a heating and humidifying condition.

In particular, organic EL and an organic EL display having the sealing sheet or the sealing structure of the present invention can suppress a decrease in adherence between the sealing sheet and the substrate (adherend) due to moisture intrusion and heat generated during driving of the organic EL element, can suppress property degradation of the organic EL element, and excels in durability under a heating and humidifying condition. In the same manner, a liquid crystal display and a solar cell having the sealing sheet or the sealing structure of the present invention also excel in durability under a heating and humidifying condition.

### Examples

Next, the present invention will be described in more detail by Examples, but the present invention is not limited by these Examples.

The mass-average molecular weight (Mw) and the softening point of each component used in Examples and Comparative Examples below are values measured by methods described below.

### <Mass-Average Molecular Weight (Mw)>

A value in terms of standard polystyrene, which was measured using a gel permeation chromatograph apparatus (manufactured by Tosoh Corporation, product name "HLC-8020") under the following conditions, was used.

### (Measurement Conditions)

- Column: "TSK guard column HXL-H" "TSK gel GMHXL (x2)" "TSK gel G2000HXL" (all manufactured by Tosoh Corporation)
- Column Temperature: 40°C
- Developing Solvent: Tetrahydrofuran
- Flow Rate: 1.0 mL/min

### <Softening Point>

A value measured in conformity with JIS K 2207 was used.

It is to be noted that details about components used in the present Examples and Comparative Examples are as follows.

### <Resin composition forming resin part (A)>

### (Manufacturing example 1) Manufacture of acrylic-based resin composition A

The resin composition forming the resin part (A) was prepared by the following method.

As monomer components, 90 parts by mass of butyl acrylate and 10 parts by mass of acrylic acid, and as a polymerization initiator, 0.2 parts by mass of azobisisobutyronitrile were put into a reactor and mixed. This was purged with nitrogen gas for 4 hours, and after the temperature was gradually increased to 60°C, a polymerization reaction was performed while stirring for 24 hours to obtain an acrylic-based copolymer (Mw = 650,000)-containing ethyl acetate solution (solid content 33 mass%).

1.5 parts by mass (solid content basis) of an isocyanate-based cross-linking agent (manufactured by Nippon Polyurethane Industry Co., Ltd., product name "CORONATE L", ethyl acetate solution of trimethylolpropane-modified tolylene diisocyanate, solid content 75 mass%) was added to 100 parts by mass (solid content) of the obtained acrylic-based copolymer-containing ethyl acetate solution and dissolved in toluene to prepare a solution of the acrylic-based resin composition A having a solid content of 20 mass%.

### <Resin composition forming resin part (B)>

As the resin composition forming the resin part (B), the following raw materials were used.
- "Oppanol B100" (product name, manufactured by BASF): polyisobutylene-based resin, Mw=1,000,000
- "Oppanol B50" (product name, manufactured by BASF): polyisobutylene-based resin, Mw=340,000
- "Oppanol B30" (product name, manufactured by BASF): polyisobutylene-based resin, Mw=200,000
- "Kraton G1726" (product name, manufactured by Kraton Performance Polymers Inc.): styrene-based copolymer mixture containing at a ratio of SEBS (Mw=70,000)/SEB (Mw=35,000)=30/70 (mass ratio), styrene content 30 mass%
- "I-MARV P-100" (product name, manufactured by Idemitsu Kosan Co., Ltd.): hydrogenated petroleum resin of copolymer of dicyclopentadiene and aromatic vinyl monomer, softening point 100°C
- "ARKON P-125" (product name, manufactured by Arakawa Chemical Industries, Ltd.): alicyclic saturated hydrocarbon resin, softening point 115°C
- "Quinton R-100" (product name, manufactured by Zeon Corporation):
   aliphatic hydrocarbon resin, softening point 96°C

### <Evaluation of water vapor transmission rate of resin part (B)>

A toluene solution of the resin composition (B) prepared in Examples and Comparative Examples shown in Table 1 was applied onto a polyethylene terephthalate film (manufactured by Lintec Corporation, product name "SP-PET38T103-1", thickness 38 µm) whose surface is silicone release-treated, as a tight release film, by a screen printing machine such that the thickness after drying is 50 µm, and drying was performed at 120°C for 2 minutes to form a resin layer composed of only the resin part (B), and a release-treated surface of a polyethylene terephthalate film (manufactured by Lintec Corporation, product name "SP-PET381130", thickness 38 µm) whose surface is silicone release-treated, as an easy release film, was attached onto the surface of the formed resin layer to obtain a sheet without a substrate, which is sandwiched between two release films and has the resin layer composed of only the resin part (B).

The surfaces of the resin layer exposed by releasing the two release films of the sheet were laminated by a polyethylene terephthalate film (manufactured by Mitsubishi Plastics, Inc., thickness 6 µm) to obtain a sample for measuring a water vapor transmission rate, which is composed of the resin layer sandwiched between two polyethylene terephthalate films.

The water vapor transmission rate was measured in conformity with JIS K 7129 under the environment at 40°C and 90% RH (relative humidity) using a transmission rate measuring instrument (manufactured by LYSSY, product name "L89-500"). It is to be noted that the water vapor transmission rate of the two polyethylene terephthalate films used for lamination was 43 g/m²/day. In other words, when the water vapor barrier property of the resin layer is completely zero, the water vapor transmission rate has a value around 43 g/m²/day. When the value becomes smaller, the water vapor barrier property of the resin layer becomes better.

### [Example 1]

In accordance with the prescription described in Table 1, the toluene solution of the resin composition used for the resin part (A) obtained in Manufacturing example 1 described above, and the toluene solution of the resin composition used for the resin part (B) were produced. The solution of the resin composition used for the resin part (A) was applied onto a release-treated surface of a tight release film (manufactured by Lintec Corporation, product name "SP-PET38T103-1" was cut into a size of 240 mmx240 mm) by a screen printing machine such that the thickness after drying is 50 µm and the line width of the resin part (A) in the lattice pattern shape (illustrated in Fig. 1(a)) is 20 mm, and drying was performed at 100°C for 2 minutes to form the resin part (A) of a resin layer. Next, in the same manner, the solution of the resin composition used for the resin part (B) was applied such that one side of the resin part (B) in the center is 100 mm, and drying was performed at 100°C for 2 minutes to form the resin part (B) of the resin layer. At this time, the solutions were applied such that the resin part (A) and the resin part (B) are present in the same manner on both surfaces of the resin layer. Furthermore, an easy release film (manufactured by Lintec Corporation, product name "SP-PET381031") was laminated on the surface of the obtained resin layer, so that the resin layer was sandwiched between two release films, and seasoning was performed at 23°C and 50% RH for 7 days to produce a sealing sheet in which the resin layer is protected.

Then, the easy release sheet of the produced sealing sheet was released and removed, and a gas barrier film was laminated on the exposed resin layer to produce the sealing sheet on which the gas barrier film is laminated.

It is to be noted that the gas barrier film used here was manufactured by the following method. As a support substrate, a gas barrier film obtained by providing an anchor layer composed of an acrylic resin having a thickness of 100 nm on one surface of a polyester film having a thickness of 100 µm, and then, providing an inorganic layer composed of silicon oxide having a thickness of 100 nm on the anchor layer was used.

Then, an anode, a hole transport layer, a light-emitting layer, and a cathode were sequentially formed on a glass plate as a substrate (adherend) (arithmetic average roughness Ra: 2 nm, maximum projection height Rp: 18 nm), so that an organic EL display element (object to be sealed) having a structure of anode/hole transport layer/light-emitting layer/cathode was provided. The anode was formed by forming a film of ITO by a sputtering method, and then, patterning the film by etching. In addition, the hole transport layer was formed by a vapor deposition method using α-naphthyl phenyl diamine. The above-described light-emitting layer was formed using tris(8-quinolinol)aluminum. As the above-described cathode, a cathode having a double layer structure was formed by a vapor deposition method using calcium and silver.

Then, the resin layer exposed by releasing and removing the tight release sheet of the produced sealing sheet on which the gas barrier film is laminated was attached at room temperature such that the manufactured object to be sealed on the substrate (adherend) is sealed to manufacture a sealing structure.

### [Example 2]

A sealing structure was manufactured by the same method as Example 1 except that the solutions were applied such that the line width of the resin part (B) is 20 mm in the shape illustrated in Fig. 1(b) instead of applying the solutions in the lattice pattern in Example 1. It is to be noted that the solutions were applied such that the resin part (A) and the resin part (B) are present in the same manner on both surfaces of the resin layer.

### [Example 3]

A sealing structure was manufactured by the same method as Example 1 except that the solutions were applied such that the line width of the resin part (A) is 20 mm in the shape illustrated in Fig. 1(c) instead of applying the solutions in the lattice pattern in Example 1. It is to be noted that the solutions were applied such that the resin part (A) and the resin part (B) are present in the same manner on both surfaces of the resin layer.

### [Example 4]

A sealing structure was manufactured by the same method as Example 1 except that the prescription of the resin composition used for the resin part (B) described in Table 1 was used.

### [Example 5]

A sealing structure was manufactured by the same method as Example 1 except that the prescription of the resin composition used for the resin part (B) described in Table 1 was used.

### [Comparative Example 1]

A sealing structure was manufactured by the same method as Example 1 except that the resin layer was formed by applying only the resin composition used for the resin part (B) described in Table 1 without using the resin composition used for the resin part (A) obtained in Manufacturing example 1 described above.

### [Comparative Example 2]

A sealing structure was manufactured by the same method as Comparative Example 1 except that the resin layer was formed by applying only the resin composition used for the resin part (A) described in Table 1 without using the resin composition used for the resin part (B) obtained in Manufacturing example 1 described above.

The evaluation of the sealing performance of the sealing sheet manufactured in each of Examples and Comparative Examples was measured by a method described below. The results are shown in Table 1.

### <Evaluation of sealing performance>

The sealing structure manufactured in each of Examples and Comparative Examples described in Table 1 was stored in a thermo-hygrostat set to be 40°C and 90% RH (relative humidity) for 4 weeks and 8 weeks under the conditions, and then taken out. For the sealing structure that was taken out, the sealing structure was made to emit light under a drive condition of 10 mA/cm², the light-emitting part was observed at 25-fold magnification using a stereoscopic microscope, and the presence or absence of dark spots was observed. The evaluation of the sealing performance was evaluated by the criterion described below.
- A: The number of dark spots is 0.
- B: The number of dark spots is 1 to 3.
- C: The number of dark spots is 4 or more.

**Table 1**

| | Resin Composition | | | | | Application Pattern of Sealing Sheet (Plane) | Evaluation of Sealing Performance | |
|---|---|---|---|---|---|---|---|---|
| | Resin Part (A) | | Resin Part (B) | | | | | |
| | Material Name | Amount Blended^{*1} [Parts by Mass] | Material Name | Amount Blended^{*1} [Parts by Mass] | Water Vapor Transmission Rate [g/m²/day] | | 4 Weeks Later | 8 Weeks Later |
| Example 1 | Acrylic-based Resin Composition A | 100 | Oppanol B100 | 100 | 13.0 | Lattice Pattern Fig. 1(a) | A | A |
| | | | I-MARV P-100 | 70 | | | | |
| Example 2 | Acrylic-based Resin Composition A | 100 | Oppanol B100 | 100 | 13.0 | Frame Pattern Fig. 1(b) | A | A |
| | | | I-MARV P-100 | 70 | | | | |
| Example 3 | Acrylic-based Resin Composition A | 100 | Oppanol B100 | 100 | 13.0 | Frame Pattern Fig. 1(c) | A | A |
| | | | I-MARV P-100 | 70 | | | | |
| Example 4 | Acrylic-based Resin Composition A | 100 | Oppanol B50 | 90.9 | 3.4 | Lattice Pattern Fig. 1(a) | A | A |
| | | | Oppanol B30 | 9.1 | | | | |
| | | | ARKON P-115 | 20 | | | | |
| Example 5 | Acrylic-based Resin Composition A | 100 | Oppanol B50 | 72.7 | 4.5 | Lattice Pattern Fig. 1(a) | A | A |
| | | | Oppanol B30 | 7.3 | | | | |
| | | | Kraton G1726 | 20 | | | | |
| | | | Quinton R-100 | 30 | | | | |
| Comparative Example 1 | - | 0 | Oppanol B100 | 100 | 13.0 | No Pattern | C | C |
| | | | I-MARV P-100 | 70 | | | | |
| Comparative Example 2 | Acrylic-based Resin Composition A | 100 | - | 0 | 20.1 | No Pattern | C | C |

| | | | | | | | | |
|---|---|---|---|---|---|---|---|---|
| *1: In Examples 1 to 3, a 15 mass% toluene solution was applied. In Examples 4 and 5, and Comparative Examples 1 and 2, a 20 mass% toluene solution was applied. | | | | | | | | |

As shown in Table 1, in the sealing structures manufactured in Examples 1 to 5, generation of dark spots was not observed even after 8 weeks storage. In contrast, in Comparative Examples 1 and 2, dark spots were observed on all surfaces of the sealing structures even after 4 weeks storage. In addition, as shown in the results of Examples 1 to 3, it was confirmed that the sealing sheet in which the resin part (A) or the resin part (B) forms a closed region on at least one surface of the resin layer of the sealing sheet of the present invention and an organic EL element is arranged in the closed region has excellent sealing performance regardless of the shape of the closed region.

### Industrial Applicability

When manufacturing a sealing structure, the sealing sheet of the present invention can also prevent moisture that intrudes into the sealing structure from between a substrate (adherend) and the sealing sheet, in addition to a preventing effect on moisture intrusion due to low water vapor transmittivity of the sealing sheet itself, and thus, a sealing structure obtained by sealing with the sealing sheet, and a device having the sealing sheet or the sealing structure excel in durability under heating and humidifying.

Therefore, the sealing sheet of the present invention is suitably used for sealing, for example, an organic EL element, a liquid crystal display element, a solar cell element, or the like. Furthermore, the sealing sheet or the sealing structure is also suitably used for a device having the above-described element, such as a light-emitting device, a display device, or a solar cell.

### Reference Signs List

1 resin part (A)
2 resin part (B)
3 closed region
4 resin layer
5 support
6 release sheet
7 object to be sealed
8 sealing sheet
9 substrate (adherend)
101 to 106 surface of resin layer of sealing sheet
201 to 204 cross-section of sealing sheet
301(a) plane of sealing structure
301(b), 301(c) cross-section of sealing structure
302(a) plane of sealing structure
302(b), 302(c) cross-section of sealing structure

## Claims

1. A sealing sheet having a resin layer comprising a resin part (A) formed by a resin composition comprising one or more resins selected from the group consisting of an acrylic-based resin and a urethane-based resin, and a resin part (B) having a water vapor transmission rate measured in conformity with JIS K 7129 of 15 g/m²/day or less, wherein
the resin part (A) and the resin part (B) are present on at least one surface of the resin layer.

2. The sealing sheet according to claim 1, wherein, on the at least one surface of the resin layer, the resin part (A) or the resin part (B) forms a closed region, and the other resin part is present in the closed region.

3. The sealing sheet according to claim 1 or 2, wherein, on the at least one surface of the resin layer, a ratio of a total surface area of the resin part (A) to a total surface area of the resin part (B) [(A) area/(B) area] is 10/90 to 90/10.

4. The sealing sheet according to any one of claims 1 to 3, wherein the resin layer is provided on a support.

5. The sealing sheet according to claim 4, wherein only the resin part (B) is present on a surface of the resin layer on the side of the support and the resin part (A) and the resin part (B) are present on the other surface of the resin layer.

6. The sealing sheet according to claim 4 or 5, wherein the support is a gas barrier film.

7. The sealing sheet according to any one of claims 1 to 6, wherein a resin composition forming the resin part (B) comprises one or more resins selected from the group consisting of a butyl rubber, a polyisobutylene-based resin, a styrene- based copolymer, a polyisoprene-based resin, a polybutadiene-based resin, and a polybutene-based resin.

8. The sealing sheet according to claim 7, wherein the resin composition forming the resin part (B) comprises a polyisobutylene-based resin having a mass-average molecular weight of 270,000 to 600,000 (b-1) and a polyisobutylene-based resin having a mass-average molecular weight of 50,000 to 250,000 (b-2).

9. The sealing sheet according to claim 7, wherein the resin composition forming the resin part (B) comprises a polyisobutylene-based resin having a mass-average molecular weight of 20,000 or more (b-3), and one or more styrene-based copolymers selected from the group consisting of a styrene-butadiene-styrene triblock copolymer (SBS), a styrene-(ethylene-co-butylene)-styrene triblock copolymer (SEBS), a styrene-isobutylene diblock copolymer (SIB), and a styrene-isobutylene-styrene triblock copolymer (SIBS), (b-4).

10. The sealing sheet according to claim 9, wherein a softening point of the styrene-based copolymer (b-4) is 80 to 200°C.

11. The sealing sheet according to any one of claims 1 to 10, wherein the resin composition forming the resin part (B) further comprises a tackifier having a softening point of 135°C or less.

12. The sealing sheet according to any one of claims 1 to 11, which is used for sealing an organic EL element.

13. A sealing structure obtained by sealing an object to be sealed, which is provided on a substrate (adherend), with the sealing sheet according to any one of claims 1 to 12.

14. The sealing structure according to claim 13, wherein the object to be sealed is positioned in a region closed by the resin part (B) on a surface of the sealing sheet.

15. The sealing structure according to claim 13 or 14, wherein the object to be sealed is an organic EL element, an organic EL display element, a liquid crystal display element, or a solar cell element.

16. The sealing structure according to any one of claims 13 to 15, wherein the substrate (adherend) is a glass plate or a gas barrier film.

17. A light-emitting device, a display device, or a solar cell comprising the sealing sheet according to any one of claims 1 to 12 or the sealing structure according to any one of claims 13 to 16.
